(19) Europäisches Patentamt / European Patent Office / Office européen des brevets

(11) **EP 3 452 839 B1**

(12) **EUROPÄISCHE PATENTSCHRIFT**

(45) Veröffentlichungstag und Bekanntmachung des Hinweises auf die Patenterteilung:
**17.04.2024** **Patentblatt 2024/16**

(21) Anmeldenummer: **18728069.8**

(22) Anmeldetag: **22.05.2018**

(51) Internationale Patentklassifikation (IPC):
**G01R 19/165** (2006.01)    **G01R 15/14** (2006.01)
**G01R 31/52** (2020.01)

(52) Gemeinsame Patentklassifikation (CPC):
**G01R 19/16509; G01R 15/148; G01R 31/52**

(86) Internationale Anmeldenummer:
**PCT/EP2018/063325**

(87) Internationale Veröffentlichungsnummer:
**WO 2018/215424 (29.11.2018 Gazette 2018/48)**

(54) **VORRICHTUNG ZUR ERFASSUNG ELEKTRISCHER STRÖME AN ODER IN DER NÄHE ELEKTRISCHER LEITER**

DEVICE FOR DETECTING ELECTRICAL CURRENTS ON OR NEAR ELECTRICAL CONDUCTORS

DISPOSITIF DE DÉTECTION DE COURANTS ÉLECTRIQUES AU NIVEAU OU AU VOISINAGE D'UN CONDUCTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2017 DE 102017111477**
**28.03.2018 DE 102018107475**

(43) Veröffentlichungstag der Anmeldung:
**13.03.2019 Patentblatt 2019/11**

(73) Patentinhaber: **DEHN SE**
**92318 Neumarkt i.d. OPf. (DE)**

(72) Erfinder:
• **ZAHLMANN, Peter**
**92318 Neumarkt (DE)**
• **BIRKL, Josef**
**92334 Berching (DE)**
• **BÖHM, Thomas**
**92366 Hohenfels (DE)**
• **BÜHLER, Klaus**
**90542 Eckental (DE)**
• **MAGET, Johannes**
**92331 Parsberg (DE)**
• **EHRHARDT, Arnd**
**92318 Neumarkt (DE)**
• **SHULZHENKO, Eduard**
**98693 Ilmenau (DE)**

(74) Vertreter: **Prinz & Partner mbB**
**Patent- und Rechtsanwälte**
**Rundfunkplatz 2**
**80335 München (DE)**

(56) Entgegenhaltungen:
**WO-A-2017/036793     DE-A1- 19 733 268**
**DE-A1- 19 930 089     RU-C1- 2 554 282**

EP 3 452 839 B1

**Beschreibung**

Die Erfindung betrifft eine Verwendung einer Vorrichtung zur Klassifizierung von Blitz- und Überstromereignissen, wobei die Vorrichtung mindestens einen Reed-Kontakt als magnetisch ansprechenden Schalter aufweist, welcher so in der Nähe des elektrischen Leiters angeordnet ist, dass bei einem signifikanten Stromfluss durch den elektrischen Leiter das entstehende magnetische Feld den Schalter auslöst und eine mit dem Schalter in Verbindung stehende Auswerteelektronik anstößt.

Aus der DE 2 826 247 C2 ist ein Kurzschlussanzeiger für elektrische Leitungen vorbekannt.

Der Kurzschlussanzeiger weist einen vom Magnetfeld einer elektrischen Leitung gesteuerten Reed-Kontakt und eine elektronische Selbsthalteschaltung auf. Die Selbsthalteschaltung ist als Flip-Flop-Schaltung ausgebildet, die sowohl ein elektronisches Zählwerk als auch einen Taktgenerator steuert. Der Taktgenerator stößt einen Blinksignalgeber an. Das elektronische Zählwerk stellt nach Zeitablauf die Flip-Flop-Schaltung zurück und stoppt den Taktgenerator.

Der eingesetzte Reed-Kontakt ist in einer zum Stromleiter parallelen Ebene angeordnet, derart, dass im Augenblick eines Kurzschlusses ein entsprechend großes Magnetfeld erzeugt wird, welches auf den Reed-Kontakt einwirkt und diesen zumindest kurzzeitig schließt.

Damit gelangt eine Versorgungsspannung auf den Eingang der Flip-Flop-Schaltung, so dass diese in die Selbsthaltestellung übergeht.

Durch Verdrehung des Reed-Kontaktes um die gedachte Längsachse eines Gehäuses ist dessen Empfindlichkeit verringert. Hierdurch kann werkseitig der Kurzschlussanzeiger auf bestimmte abgestufte Auslöseströme zum Beispiel im Bereich von 200 - 400 A eingestellt werden.

Die DE 103 29 223 B9 offenbart einen Kurzschlussstromsensor, der die Kraft des Magnetfeldes eines Kurzschlussstromes nutzt, um einen Reed-Kontakt zu schließen, der derart auf einer Leiterplatte montiert ist, dass dieser durch eine Drehung zwischen 0 und 90° auf einen bestimmten Auslösestrom einstellbar ist.

Die DE 27 00 995 A1 betrifft ein Überwachungssystem für einen elektrischen, stromdurchflossenen Verbraucher.

Bei dem Verbraucher handelt es sich insbesondere um Brems- oder Schlussleuchten von Kraftfahrzeugen. In dem durch die Zuleitung des Verbrauchers fließenden Strom erzeugten Magnetfeld wird ein magnetfeldabhängiger Schalter angeordnet, der zu einer Anzeigeeinrichtung führt. Als Schalter kommt insbesondere ein Reed-Kontakt zum Einsatz.

Bei einer bevorzugten Ausführungsform ist der Schalter im Inneren einer von der Verbraucherzuleitung gebildeten Spule angeordnet, so dass sich das jeden einzelnen Leiter umgebende Magnetfeld der benachbarten Spulenwindungen überlagert, um eine ausreichende Ansprechempfindlichkeit zu erhalten.

In einer Ausbildung der dortigen Lehre ist die Spule und der magnetfeldabhängig betätigbare Schalter als Baueinheit zusammengefasst, welche in die Zuleitung des Verbrauchers einschleifbar ist.

Bei der Anordnung zur selektiven Auslösung von hintereinander geschalteten, selektiv gestarteten Schutzschaltern, in der ein vom Kurzschluss direkt betroffener Schutzschalter ein Blockiersignal an ein Auslösesystem ausgibt gemäß DE 199 30 089 A1 ist mit jeder Hauptstrombahn eines nachgeschalteten Schutzschalters ein Schutzrohrkontakt magnetisch gekoppelt und elektrisch mit dem Auslösesystem des vorgeordneten Schutzschalters verbunden.

Bevorzugt ist der Schutzrohrkontakt in der Nähe einer Anschlussklemme des Schutzschalters angeordnet.

Den vorstehend geschilderten Lösungen des Standes der Technik ist gemeinsam, dass ein Reed-Kontakt die Basis eines Schalters bildet, wobei der Schalter durch ein Magnetfeld betätigbar ist. Bei ausreichender magnetischer Energie gelangen die Kontaktzungen eines an sich bekannten Reed-Schalters in eine kontaktschließende Position mit der Folge, dass der Stromkreis, in welchem der Schalter befindlich ist, geschlossen wird. Auf der Basis der Nutzung derartiger Reed-Schalter können Stromkreise überwacht und deren Funktion signalisiert werden. Darüber hinaus kann ein Kurzschlussstrom festgestellt werden, indem der Kurzschlussstrom selbst als Schwellwert definiert wird, dessen Magnetfeld in der Lage ist, den Reed-Kontakt, das heißt den Schalter, zu schließen.

Die RU 2 554 282 C1 offenbart ein Verfahren zum Erfassen von elektrischen Strömen in einem elektrischen Leiter sowie eine Vorrichtung dafür. Die Vorrichtung umfasst eine Vielzahl von Reed-Kontakten, die in jeweils unterschiedlichem Abstand zum elektrischen Leiter angeordnet und mit einem Mikrocontroller verbunden sind. Die Reed-Kontakte sind derart angeordnet, dass sie mit zunehmendem Abstand erst bei stetig größerem Stromfluss durch den elektrischen Leiter ansprechen. Aus den Zeitpunkten, zu denen die Reed-Kontakte auslösen (und sich nach Abklingen des Stroms wieder öffnen) wird ein Polynom ermittelt, welches den Stromverlauf näherungsweise beschreibt. Das Polynom wird anschließend genutzt, um die Amplitude des detektierten Stroms zu ermitteln.

Die DE 197 33 268 A1 beschreibt ein Verfahren zum Detektieren von Über- und Kurzschlussströmen in Leitern einer Mittel- oder Hochspannungsanlage sowie eine Einrichtung zum Durchführen des Verfahrens. Die Einrichtung verfügt über je einen Reed-Kontakt pro Leiter der Anlage, welche bei Auftreten eines durch einen Über- oder Kurzschlussstrom erzeugten Magnetfelds auslösen und auf diese Weise einen Impuls in der Einrichtung erzeugen.

Aus der WO 2017/036793 A1 ist ein Verfahren zur Erfassung von Blitzstromparametern an Anlagen mit mehreren Fangeinrichtungen und Blitzstromableitpfaden bekannt. Dazu werden zwei verschiedene Arten von Blitzstromsensoren eingesetzt, wobei ein einfacher Blitzstromerfassungssensor für jede der Fangeinrichtungen vorgesehen ist, der lediglich eine digitale Ausgabe, also eine Ja/Nein-Aussage, zum Blitzstromereignis liefert, während ein zentraler Blitzstrommesssensor zum Unterscheiden von Stoßströmen und Langzeitströmen eingesetzt wird.

Aus dem Vorgenannten ist es Aufgabe der Erfindung, eine weitergebildete Vorrichtung zur Erfassung elektrischer Ströme an oder in der Nähe elektrischer Leiter mit mindestens einem Reed-Kontakt als magnetisch ansprechender Schalter anzugeben, wobei die Vorrichtung nicht nur in der Lage ist, einen Schaltzustand mit Erreichen eines bestimmten Stromflusses im elektrischen Leiter zu definieren, sondern ebenso die Möglichkeit besteht, Stromimpulse und damit Stoßströme zu erfassen und diese zu bewerten, ohne dass ähnlich wie bei sogenannten Blitzzählern aufwändige elektronische und damit teure und störanfällige Schaltungen erforderlich sind.

Die Lösung der Aufgabe der Erfindung erfolgt mit einer Verwendung einer Vorrichtung gemäß der Merkmalskombination nach Anspruch 1, wobei die Unteransprüche mindestens zweckmäßige Ausgestaltungen und Weiterbildungen darstellen.

Im Ergebnis umfangreicher Untersuchungen hat sich in überraschender Weise herausgestellt, dass mit einer quasi räumlich gestaffelten, bezogen auf einen elektrischen Leiter beabstandeten und/oder in ihrer Empfindlichkeit gestaffelten Anordnung von mehreren Reed-Kontakten Stoßstromgrößen ermittelt und unterschieden werden können. Dabei hat sich in besonders überraschender Weise gezeigt, dass nicht nur Langzeitimpulsströme erkennbar sind, sondern auch Kurzzeitimpulsströme bewertet werden können. Die erfindungsgemäß verwendete Vorrichtung arbeitet dabei auch in rauer Umgebung und unter Einfluss mechanischer Erschütterungen und Schwingungen störungsfrei, was wiederum bezogen auf bestimmte Applikationen, zum Beispiel der Überwachung von Blitzeinschlägen in Windkraftanlagen überraschend ist.

An sich besitzen Reed-Kontakte aufgrund ihres Aufbaus eine mechanische Trägheit, welche das reproduzierbare Ansprechen bei extrem kurzzeitigen Impulsbelastungen nicht erwarten lässt. Das ermittelte definierte Ansprechen der empfindlichen Kontakte, teilweise bereits während des Impulsvorganges, ist ebenso wenig vorhersehbar, wie das ebenfalls reproduzierbare Ansprechen von Kontakten mit geringerer Empfindlichkeit bzw. höherer mechanischer Trägheit noch deutlich nach der Impulsbelastung ohne weiter einwirkendes magnetisches Feld. Weiterhin überrascht die Überlastfestigkeit, insbesondere der empfindlichen Reed-Kontakte. Es können sowohl Impulsströme von < 100 A aber auch kleine Langzeitströme sicher erfasst werden. Bei deutlich größeren Impulsbelastungen bis hin zu 250 kA mit magnetischen Feldbelastungen, welche um den Faktor 1000 oder größer oberhalb der Ansprechspannung liegen, werden die mechanischen Komponenten des jeweiligen Reed-Kontaktes durch die hohen dynamischen Kräfte nicht mechanisch zerstört oder beschädigt, so dass selbst nach derartigen Mehrfachbelastungen eine reproduzierbare Erfassung von Impulsströmen möglich ist.

Durch eine erfindungsgemäße Positionierung des jeweiligen Reed-Kontaktes und eine nahezu schleifenfreie Zuführung der Anschlüsse kann eine nachteilige Einkopplung von Strömen in dem Pfad der Kontakte so weit reduziert werden, dass die notwendigen empfindlichen Kontakte mit sehr geringen Schaltströmen durch die induzierten Ströme beim Schließen nebst gegebenenfalls hochfrequentem Prellen durch die Vermeidung von Abrissfunken nicht geschädigt werden. Eine Funkenbildung kann durch zusätzliche Beschaltungen des Reed-Kontaktes vermieden werden. Eine unerwünschte Einkopplung von Strömen in die Anschlussschleife der Reed-Kontakte kann durch aktive bzw. passive Überspannungsschutzmaßnahmen reduziert werden.

Die erfindungsgemäß verwendete Vorrichtung zur Erfassung elektrischer Ströme unter Nutzung von Reed-Kontakten kann in eine sogenannte intelligente Fangstange integriert werden oder einen Bestandteil einer solchen Fangstange darstellen, um Blitzereignisse bewerten zu können.

Gemäß einem weiteren Applikationsbeispiel kann die erfindungsgemäß verwendete Vorrichtung zur Erfassung von Strömen in solchen Leitern genutzt werden, die Bestandteil einer baulichen Anlage sind und welche entsprechend EN 62305-3 als Ableitungseinrichtung genutzt werden. Die Reed-Kontakte können auch an bzw. in der Nähe elektrisch leitfähiger Bauteile installiert werden, welche prinzipiell nicht für den Blitzschutz vorgesehen sind, über die aber ein Blitzteilstrom fließen kann. Beispielhaft sei hierzu auf Förderseile von Seilbahnen, Halteseile von Kränen oder dergleichen verwiesen. Diesbezüglich gelingt es, frühzeitig eine mögliche Schädigung durch Blitzteilströme an solchen Seilen zu erkennen, um geeignete Maßnahmen, zum Beispiel Austausch geschädigter Seile, in die Wege zu leiten.

Die durch einen Einsatz der Reed-Kontakte sich ergebende galvanische Trennung und den Abstand der Vorrichtung mit ihren elektronischen Komponenten von der blitzstromdurchflossenen Ableitung ist ein störungsfreier Betrieb über einen langen Zeitraum ohne Wartungsaufwand möglich.

Ebenso kann die erfindungsgemäß verwendete Vorrichtung Bestandteil von Überspannungsableitern sein oder zur Bewertung der Belastung von Überspannungsableitern herangezogen werden, indem nämlich die erfindungsgemäß verwendete Vorrichtung in den betreffenden Strompfad integriert, respektive diesem zugeordnet wird.

Damit stellt die erfindungsgemäß verwendete Vorrichtung eine kostengünstige Alternative zu ansonsten zum Einsatz kommenden aufwändigen Messsystemen, zum Beispiel unter Nutzung von sogenannten Rogowski-Spulen dar.

Die erfindungsgemäß verwendete Vorrichtung ermöglicht bei ihrer Anwendung das Erreichen einer Doppelfunktion, indem einerseits Störstromimpulse, zum Beispiel auf der Basis von Blitzereignissen, erfasst werden und diese hinsichtlich der Impulsform und Impulsdauer aber auch der Stromhöhe unterscheidbar sind.

Die Vorrichtung zur Erfassung elektrischer Ströme an oder in der Nähe elektrischer Leiter geht demnach von einem Reed-Kontakt als magnetisch ansprechenden Schalter aus, welcher so in der Nähe des elektrischen Leiters angeordnet ist, dass bei einem signifikanten Stromfluss durch den Leiter das entstehende magnetische Feld den Schalter auslöst und eine mit dem Schalter in Verbindung stehende Auslöseelektronik anstößt.

Erfindungsgemäß wird für eine Detektion von Stoßstromgrößen und Unterscheidung von Langzeitimpulsströmen einerseits und Kurzzeitimpulsströmen andererseits eine Vielzahl von Reed-Kontakten in vorgegebenen, unterschiedlichen, zunehmenden Abstand zum elektrischen Leiter angeordnet.

Die Auswerteelektronik ermittelt das Ansprechen und die Schaltzeiten der jeweiligen Reed-Kontakte. Aus der Zuordnung der ermittelten Werte zu dem Reed-Kontakt, respektive dessen räumlicher Anordnung und dem Abstand zum elektrischen Leiter lässt sich die Stoßstromgröße und aus der Schaltzeit die Impulsform, bevorzugt unter Einsatz eines Mikrocontrollers ermitteln oder bestimmen.

Erfindungsgemäß können nicht nur Reed-Kontakte mit Schließerfunktion eingesetzt werden. Ebenso besteht die Möglichkeit, öffnende Reed-Kontakte zu nutzen. Entsprechende öffnende Kontakte können in Verbindung mit einem Permanentmagneten so realisiert werden, dass das Ansprechverhalten des Kontaktes einstellbar ist.

Es liegt daher im Sinne der Erfindung, das Ansprechverhalten bezogen auf die Unterscheidung der Ströme nicht nur durch eine räumlich beabstandete Ausbildung einzustellen, sondern auch auf weitere Kriterien zurückzugreifen. Zur Einstellung von Grenzen des Ansprechverhaltens der jeweiligen Reed-Kontakte kann eine Schirmung zur Anwendung kommen. Diese Schirmung kann als metallische Hülse oder metallische Schicht ausgeführt werden. Gegen hochfrequente Vorgänge sind beispielsweise metallische Hülsen oder Schichten zur Erzeugung von Wirbelströmen auf der Basis von Kupfer oder Alumaterialien zweckmäßig. Zur Reduzierung der Empfindlichkeit bei niederfrequenten Vorgängen können Materialien mit hoher Permeabilität, zum Beispiel weichmagnetische Stähle eingesetzt werden.

Zur Nutzung beider Effekte sind Materialien mit hoher Permeabilität zusätzlich mit elektrisch leitfähigen Beschichtungen, zum Beispiel aus Kupfer einsetzbar. Aufgrund der Sättigung von Materialien mit hoher Permeabilität bei starken Magnetfeldern ist eine Staffelung der Schirmmaterialien, welche den jeweiligen Reed-Kontakt umgeben, vorteilhaft.

Durch die Schirmung kann also die Empfindlichkeit der Reed-Kontakte individuell eingestellt und verändert werden, so dass letztendlich die Verwendung von Standard-Reed-Kontakten mit gleicher Empfindlichkeit und gleicher Bauform möglich wird.

Aufgrund der Grenzen unterschiedlicher räumlicher Beabstandung der Reed-Kontakte zum elektrischen Leiter können alternativ oder ergänzend öffnende Kontakte gleicher Bauart mit unterschiedlichen Gegenfeldmagneten verwendet werden. Ebenso ist der Einsatz von Schließern möglich, welche neben der Distanz zusätzlich gegen die Einwirkung von Magnetfeldern geschirmt sind.

In einer Ausführungsform der Erfindung ist der elektrische Leiter Bestandteil einer Blitzstromableitung, einer Fangstange oder eines leitfähigen Bauteiles, über das prinzipiell ein Blitzstrom fließen kann.

In einer weiteren Ausführungsform der Erfindung ist der elektrische Leiter Bestandteil eines stoßstromführenden Überspannungsableiters.

Die Auswerteelektronik weist neben dem bevorzugten Mikrocontroller auch einen Datenspeicher auf.

Die gespeicherten Daten können drahtlos oder drahtgebunden bzw. mittels Faseroptik (LWL) an eine übergeordnete Einheit zur Langzeitanalyse von impulsförmigen Stoßströmen bzw. Langzeitströmen übergeben werden.

Hierdurch ist es möglich, beispielsweise durch Einbindung einer Vielzahl von erfindungsgemäß verwendeten Vorrichtungen in komplexen Gebäuden, Belastungen bezüglich von Überstromereignissen zu erfassen, zu speichern und zur Standort- oder Gefahrenanalyse auszuwerten.

Um einen dauerhaften, wartungsfreien Einsatz der Vorrichtung zu gewährleisten, ist diese mit einer Langzeitstromversorgung ausgerüstet.

Weil die erfindungsgemäß verwendete Vorrichtung sich üblicherweise in einem sogenannten Sleep-Modus befindet und erst beim Auftreten von Überstromereignissen aktiviert wird, treten nur äußerst geringe Ruheströme auf, welche zu gewünschten langen Einsatzzeiten ohne Wechsel einer Batterie bzw. eines Akkumulators führen.

In einer Ausgestaltung der Erfindung kann die erfindungsgemäß verwendete Vorrichtung auch Energie aus dem Netz ziehen, mit welchem der stromdurchflossene Leiter üblicherweise verbunden ist.

Die erforderliche Energie zur Impulsregistrierung bzw. zum Betrieb der Auswerteschaltung kann aus dem eigentlichen Stör- bzw. Messsignal, das heißt aus dem Impuls selbst, gewonnen werden.

Eine alternative Möglichkeit zur Betriebsenergiegewinnung ist das sogenannte Energy Harvesting. Hierbei kann eine Energieerzeugung aus einer Bewegung oder aber auch unter Rückgriff auf photovoltaische Elemente realisiert werden.

In Weiterbildung der Erfindung weist die Vorrichtung ein Funkmodul zur Datenübertragung auf, wobei die Datenübertragung erfindungsgemäß erst nach Ablauf einer vorbestimmten Zeitspanne nach Abklingen des letzten Stoßstromimpulses ausgelöst wird. Auf diese Weise wird eine störungsfreie Datenübertragung gewährleistet.

In einer Ausführungsform der Erfindung sind mindestens die Reed-Kontakte auf einem flächigen Verdrahtungsträger, beispielsweise einer kupferbeschichteten Leiterplatte, fixiert, wobei eine erste Gruppe von Reed-Kontakten auf einer ersten der Seiten des Verdrahtungsträgers und eine zweite Gruppe von Reed-Kontakten auf der der ersten Seite gegenüberliegenden zweiten Seite des Verdrahtungsträgers angeordnet ist.

Dabei enthält die erste Gruppe beispielsweise zwei Reed-Kontakte und die zweite Gruppe beispielsweise einen Reed-Kontakt.

In einer bevorzugten Ausbildung der Erfindung ist die Winkellage der Gruppen von Reed-Kontakten bezogen auf den elektrischen Leiter fest vorgegeben und nicht variabel, um reproduzierbare Messergebnisse zu erreichen.

Weiterhin ist erfindungsgemäß ein die Komponenten der Vorrichtung aufnehmendes Gehäuse ausgebildet, welches eine Stirn- oder Seitenfläche besitzt, die mit Mitteln zur Kennzeichnung der Lage und/oder zur Befestigung des elektrischen Leiters versehen ist.

Auf diese Weise wird beim Einsatz bzw. der Montage der Vorrichtung an oder in der Nähe eines elektrischen Leiters für eine korrekte Zuordnung zwischen dem sich bei Stromfluss ausbildenden Feld um den Leiter und den im Gehäuse befindlichen Reed-Kontakten gewährleistet.

Dadurch, dass das Gehäuse keine Öffnungen zur Aufnahme oder Durchführung des elektrischen Leiters aufweisen muss, kann selbiges auf höchste Schutzgrade, das heißt zum Einsatz im Freien und unter kritischen Umweltbedingungen ausgelegt werden.

In einer besonderen Variante der erfindungsgemäß verwendeten Vorrichtung ist diese so ausgelegt, dass eine Anordnung an oder in der Nähe von Blitzableiterseilen von Rotorblättern in Windkraftanlagen erfolgt. Mittels einer nachgeordneten Zähleinrichtung kann die Anzahl, aber auch die Stärke und die Impulsform von Blitzstromereignissen erfasst werden, um hieraus zu schlussfolgern, ob womöglich die an der Oberfläche von Rotorblättern von Windkraftanlagen befindlichen sogenannten Rezeptoren bereits übermäßig belastet bzw. aufgeschmolzen sind, so dass ein Wartungseinsatz bzw. eine Reparatur planmäßig einordenbar ist.

Die erfindungsgemäß verwendete Vorrichtung kann auch zur Überwachung und Bewertung von möglichen Blitzeinschlägen in Förderseilen, zum Beispiel von Seilbahnen, genutzt werden. Die Erfassung der Blitzströme in den Förderseilen wird durch entsprechend angeordnete und ausgelegte Sensoren mit Reed-Kontakten im Sinne der erläuterten Lehre realisiert. Wenn Blitzströme oder Blitzteilströme erfasst wurden, erfolgt eine Meldung an eine übergeordnete Kontrolleinrichtung. Hieraus kann dann auf die Notwendigkeit einer Kontrolle des Förderseiles geschlossen werden und gegebenenfalls eine Betriebsunterbrechung anzuordnen sein. Besonders problematisch bei derartigen Anwendungen ist die Detektion von Langzeitströmen. Langzeitströme sind wesentlich für auftretende Ausschmelzungen am Förderseil, die vor allem bei Wintergewittern möglich sind.

Die vorgeschlagene energieautarke Arbeitsweise der erfindungsgemäß verwendeten Erfassungsvorrichtung ohne galvanische Anbindung an ein Versorgungsnetz hat den Vorteil, dass keine Trennungsabstände zur Messeinrichtung einzuhalten sind.

Die erfindungsgemäße Verwendung der vorgestellten Vorrichtung zielt auf die Erfassung und Klassifizierung von Blitz- und Überstromereignissen, auch solchen, die nicht blitzstoßstrombedingt sind, jedoch einen Stoßstromcharakter aufweisen im Bereich von > 50 A bis hin zu 200 kA und auf eine Erfassung von Ereignissen der Impulsformen als Langzeitimpuls mit $T \geq 10$ ms sowie Impulsformen derart 10/350 µs und 8/20 µs.

Die Erfindung soll nachstehend anhand eines Ausführungsbeispieles sowie von Figuren näher erläutert werden.

Die Figur 1 zeigt hierbei eine Prinzipanordnung der erfindungsgemäß verwendeten Vorrichtung mit beispielsweise drei Reed-Kontakten in einem definierten Abstand zum elektrischen Leiter.

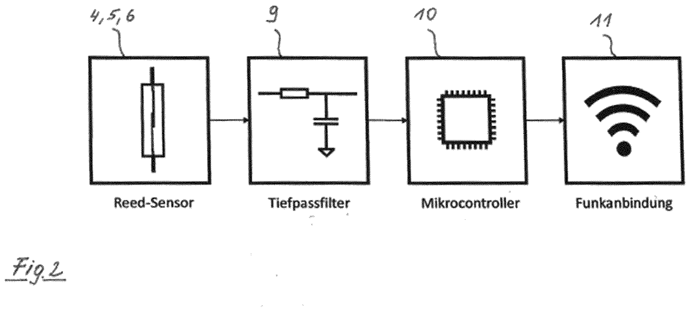

Die Figur 2 zeigt ein vereinfachtes Blockschaltbild der Auswerteelektronik mit einem dem jeweiligen Reed-Sensor 4; 5; 6 nachgeordnetem Tiefpassfilter 9, dessen jeweiliger Ausgang auf einen Mikrocontroller 10 führt, welcher ausgangsseitig mit einer Funkschnittstelle 11 in Verbindung steht.

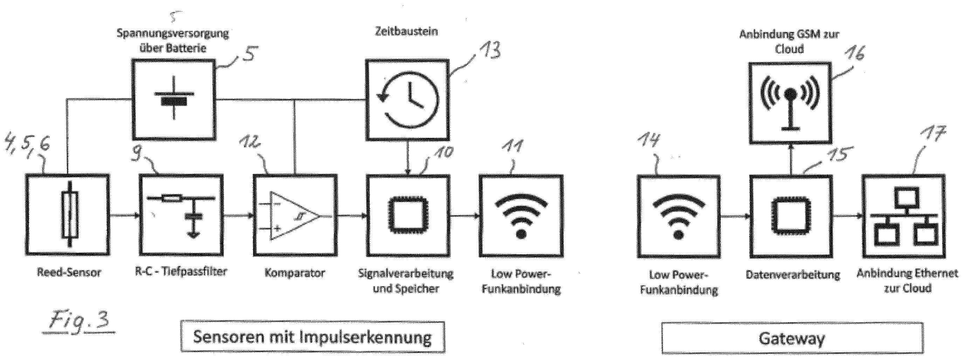

Bei dem Blockschaltbild gemäß Figur 3 wird wiederum von Reed-Sensoren 4; 5; 6 ausgegangen, die mit einem R-C-Tiefpassfilter 9 in Verbindung stehen.

Zur Ermittlung der Schaltzeit des jeweiligen Reed-Sensors 4; 5; 6 stehen die Tiefpassfilter jeweils mit dem Eingang eines Komparators 12 in Verbindung, dessen Ausgang auf den Mikrocontroller 10 nebst Speichereinheit führt.

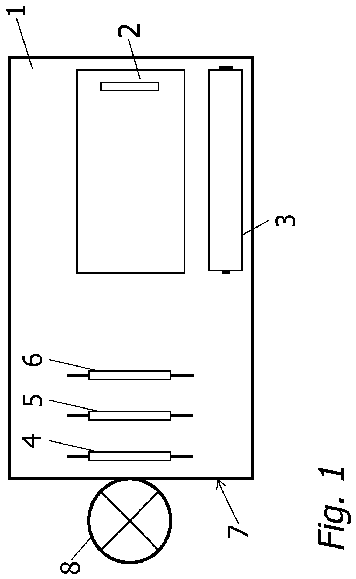

Diesbezüglich ist ein Zeitbaustein 13 vorhanden, der auf den Vergleichseingang des Komparators 12 führt. Zur Spannungsversorgung wird die zur Figur 1 bereits erläuterte Batterie 5 eingesetzt. Mit Hilfe des Zeitbausteines 13 und dem Mikrocontroller 10 lässt sich signalverarbeitungstechnisch aus der Schaltzeit des jeweiligen Reed-Sensors oder Reed-Kontaktes 4; 5; 6 die erfasste Impulsform bestimmen.

Die Baugruppen 11 und 14 bilden eine Luftschnittstelle und gewährleisten eine drahtlose Datenübertragung der detektierten Stoßstromgrößen.

Eine weitere Signalverarbeitungs- und Steuereinheit 15 steht mit einem Kommunikationsbaustein 16 in Verbindung, um z.B. über GSM eine Cloud-Anbindung zu gewährleisten. Alternativ kann mit Hilfe des Bausteines 17 eine klassische Internetanbindung zur Datenauswertung sowie zur Langzeitanalyse realisiert werden.

Die Vorrichtung gemäß Ausführungsbeispiel nach Figur 1 geht von einer Leiterplatte 1 aus, welche eine Auswerteeinheit mit Funkmodul 2 sowie eine langzeitstabile Stromversorgung in Form einer Batterie 3 aufweist.

An bzw. auf einem flächigen Seitenabschnitt der Leiterplatte 1 bzw. Verdrahtungsträgers sind drei beabstandete Reed-Kontakte 4, 5 und 6 angeordnet, die sich im Wesentlichen parallel zueinander befinden.

An einer quasi Anschlagkante 7 der Leiterplatte 1 wird ein elektrischer Leiter 8 herangeführt. Hier kann es sich beispielsweise um ein Ableiterseil eines Rotors einer Windkraftanlage handeln.

Wird das Ableiterseil 8 von einem Stoßstrom durchflossen, bildet sich um das Ableiterseil ein magnetisches Feld aus, welches die beabstandeten Reed-Kontakte 4, 5, 6 in unterschiedlicher Stärke durchdringt.

Beispielsweise wird davon ausgegangen, dass der Reed-Kontakt 4 einen Abstand von 5 mm zum Leiter inne hat, der Reed-Kontakt 5 einen Abstand zum Leiter von 15 mm und der Reed-Kontakt 6 einen Abstand vom Leiter von 105 mm aufweist.

Der Reed-Kontakt 4 ist in der Lage, Langzeitimpulse mit einem $Imin \geq 50$ A und einer Impulsdauer von $T \geq 10$ ms zu erfassen. Ebenso kann der im engsten Abstand zum Ableiterseil 8 stehende Reed-Kontakt 4 Stoßstromimpulse der Impulsform 10/350 $\mu$s mit $Imin \geq 60$ A und Stoßstromimpulse der Impulsform 8/20 $\mu$s mit $Imin \geq 70$ A detektieren.

Der Reed-Kontakt 5 ist in der Lage, Impulsströme der Impulsform 10/350 $\mu$s mit $Imin \geq 200$ A und Impulsströme 8/20 $\mu$s mit $Imin \geq 750$ A zu detektieren.

Das im Abstand von ca. 105 mm vom Ableiterseil 8 befindliche Reed-Kontakt-Relais 6 ist in der Lage, Impulse der Impulsform 10/350 $\mu$s mit $Imin \geq 4,5$ kA und Impulse der Impulsform 8/20 $\mu$m mit $Imin \geq 67$ kA zu erfassen.

Mit Hilfe der in der Vorrichtung integrierten Auswerteelektronik können die unterschiedlichen Schaltzeiten der Reed-Kontakte je nach Impulsform erfasst und ausgewertet werden, so dass erkennbar ist, um welche Impulsformen mit welcher Impulsdauer es sich handelt. Hierzu findet eine Schaltungsanordnung nach Figur 3 bevorzugt Anwendung.

Gleichfalls kann durch das selektive Ansprechen der Reed-Kontakte bei entsprechenden Stoßströmen eine Unterscheidung im Bereich von etwa 60 A bis hin zu 250 kA vorgenommen werden.

Bei einem Blitz- oder Stoßstromereignis wird dieses zunächst durch Ansprechen mindestens eines Reed-Kontaktes erfasst. Hiernach erfolgt eine Unterscheidung der gemessenen Stromstärken durch das Ansprechverhalten der einzelnen Reed-Kontakte. Die erfassten Daten werden unter Beachtung des Zeitverlaufes bzw. des Zeitdeltas zu nachfolgenden Ereignissen gespeichert und stehen dann zur weiteren Auswertung zur Verfügung.

Mit einer im Prüffeld getesteten erfindungsgemäß verwendeten Vorrichtung liegt die erfassbare Minimalstromstärke bei etwa 45 A. Mit dem Einsatz von beispielsweise drei Reed-Kontakten können drei Impulsschwellen vorgegeben und bewertet werden. Bei einer entsprechenden Erweiterung des zur Auswertung eingesetzten Mikrocontrollers kann eine weitere Diversifizierung erfolgen, ohne das Grundprinzip der Erfindung zu verlassen.

Möglicherweise notwendig werdende Komponenten zur Langzeitspeicherung und Analyse der erfassten Werte können räumlich entfernt von der erfindungsgemäßen Vorrichtung in EMV-geschützten Räumlichkeiten angebracht werden. Dies ist möglich, da bevorzugt eine drahtlose Übertragung der durch die Vorrichtung bereitgestellten Messwerte zur nachgeordneten Auswerteeinheit erfolgt und diese Übertragung erst nach Abklingen des letzten Störereignisses auslösbar ist.

Durch eine fest eingestellte Verzugszeit zwischen auftretendem Blitzereignis und dem Senden des Ereignisprotokolls kann eine Millisekunden-genaue Zeitzuordnung bzw. ein Millisekunden-genauer Zeitstempel erreicht werden.

Folgende beispielhafte Auslöseschwellen der Reed-Kontakte ergaben sich nach durchgeführten Versuchen:

Tabelle 1: Auslöseschwellen der Reed-Kontakte

| Impulsform | reed1 | reed2 | reed3 |
|---|---|---|---|
| 8/20 $\mu$s | 350 A | 1250 A | 67 kA |
| 10/350 $\mu$s | 140 A | 260 A | 4,5 kA |
| DC-Prüffeld | 141 A | - | - |

Die Auslöseschwellen der Reed-Kontakte können stark durch den Abstand und durch die Art der Kontakte variiert werden. Bei diesen Auslöseschwellen kann zwischen einem $I_{cc\ only}$ und einem Kurzzeitimpuls unterschieden werden. Falls der 3. Reed-Kontakt bei einer höheren Stromstäre auslösen soll, kann der Abstand noch vergrößert werden. Bei den verschiedenen Ableitseilen (95 mm$^2$, $\varnothing$ = 11 mm, Isolierwandstärke = 2,5 mm, 50 mm$^2$, $\varnothing$ = 8 mm, Isolierwandstärke = 2,5 mm) konnte eine Abweichung der Auslöseschwelle von 10 A beobachtet werden. Bei 10/350 Impulsen liegt die Auslöseschwelle im Vergleich zu 8/20 Impulsen deutlich niedriger.

Unter anderem lässt sich folgende Abhängigkeit des Ansprechens ab einem gewissen Abstand zum Ableitseil zwischen den Auslöseschwellen der Reed-Kontakte der 8/20 und 10/350 Impulse erkennen.

$$\frac{\int \left(I_{8/20}(t)\right)^2 dt}{\int \left(I_{10/350}(t)\right)^2 dt} \approx 15$$

**Patentansprüche**

1. Verwendung einer Vorrichtung zur Erfassung und Klassifizierung von Blitz- und Überstromereignissen mit Stoßstromcharakter im Bereich von > 50 A bis 200 kA und Impulsformen als Langzeitimpuls mit T ≥ 10 ms sowie Impulsformen 10/350 µs und 8/20 µs,

   wobei die Vorrichtung mindestens einen Reed-Kontakt (4; 5; 6) als magnetisch ansprechenden Schalter aufweist, welcher so in der Nähe eines elektrischen Leiters (8) angeordnet ist, dass bei einem signifikanten Stromfluss durch den elektrischen Leiter (8) das entstehende magnetische Feld den Schalter auslöst und eine mit dem Schalter in Verbindung stehende Auswerteelektronik anstößt,
   wobei für eine Detektion von Stoßstromgrößen und Unterscheidung von Langzeitimpulsströmen einerseits und Kurzzeitimpulsströmen andererseits eine Vielzahl von Reed-Kontakten (4; 5; 6) in vorgegebenen, unterschiedlichen, zunehmenden Abstand zum elektrischen Leiter (8) angeordnet sind,
   wobei die Auswerteelektronik das Ansprechen und die Schaltzeiten der jeweiligen Reed-Kontakte (4; 5; 6) ermittelt, aus der Zuordnung der ermittelten Werte zu dem jeweiligen Reed-Kontakt (4; 5; 6) die Stoßstromgröße und aus der Schaltzeit die Impulsform bestimmt wird.

2. Verwendung nach Anspruch 1, **dadurch gekennzeichnet, dass** der elektrische Leiter (8) Bestandteil einer Blitzstromableitung oder einer Fangstange ist.

3. Verwendung nach Anspruch 1, **dadurch gekennzeichnet, dass** der elektrische Leiter (8) Bestandteil eines stoßstromführenden Überspannungsableiters ist.

4. Verwendung nach einem der vorangegangenen Ansprüche, **dadurch gekennzeichnet, dass** die Auswerteelektronik einen Mikrocontroller (10) und einen Datenspeicher aufweist.

5. Verwendung nach Anspruch 4, **dadurch gekennzeichnet, dass** die gespeicherten Daten drahtlos oder drahtgebunden an eine übergeordnete Einheit zur Langzeitanalyse von impulsförmigen Stoßströmen übergeben werden.

6. Verwendung nach Anspruch 4 oder 5, **dadurch ge-**

**kennzeichnet, dass** ein Funkmodul (2) zur Datenübertragung vorgesehen ist, wobei die Datenübertragung erst nach Ablauf einer vorbestimmten Zeitspanne nach Abklingen des letzten Stoßstromimpulses ausgelöst wird.

7. Verwendung nach einem der vorangegangenen Ansprüche, **dadurch gekennzeichnet, dass** diese eine autarke Langzeitstromversorgung (3) aufweist.

8. Verwendung nach einem der vorangegangenen Ansprüche, **dadurch gekennzeichnet, dass** mindestens die Reed-Kontakte (4; 5; 6) auf einem flächigen Verdrahtungsträger (1) fixiert sind, wobei eine erste Gruppe von Reed-Kontakten (4; 5; 6) auf einer der Seiten des Verdrahtungsträgers (1) und eine zweite Gruppe von Reed-Kontakten (4; 5; 6) auf der der ersten Seite gegenüberliegenden Seite des Verdrahtungsträgers (1) angeordnet ist.

9. Verwendung nach Anspruch 8, **dadurch gekennzeichnet, dass** die Winkellage der Gruppen von Reed-Kontakten (4; 5; 6) bezogen auf den elektrischen Leiter (8) fest vorgegeben ist.

10. Verwendung nach einem der vorangegangenen Ansprüche, **dadurch gekennzeichnet, dass** ein die Komponenten der Vorrichtung aufnehmendes Gehäuse ausgebildet ist, welches eine Stirn- oder Seitenfläche besitzt, die mit Mitteln zur Kennzeichnung der Lage und/oder Befestigung des elektrischen Leiters (8) versehen ist.

11. Verwendung nach einem der vorangegangenen Ansprüche, **dadurch gekennzeichnet, dass** diese jeweils an oder in der Nähe von Blitzableiterseilen von Rotorblättern in Windkraftanlagen angeordnet ist.

12. Verwendung nach einem der vorangegangenen Ansprüche, **dadurch gekennzeichnet, dass** nach Ablauf einer vorbestimmten oder einstellbaren Zeitspanne zwischen Impulsereignis und Datenweitergabe ein Zeitstempel generierbar ist.

13. Verwendung nach einem der vorangegangenen Ansprüche, **dadurch gekennzeichnet, dass** der elektrische Leiter (8) Bestandteil von nicht Blitzstrom führenden Bauteilen oder Einrichtungen, insbesondere von Förderseilen oder Tragseilen von Seilbahnen oder Kränen ist.

**Claims**

1. Use of a device for detecting and classifying lightning and overcurrent events having surge current characteristic in the range of > 50 A to 200 kA and pulse shapes as a long-term pulse with T ≥ 10 ms and pulse shapes of 10/350 μs and 8/20 μs,

> wherein the device includes at least one reed contact (4; 5; 6) as a magnetically responsive switch, which is arranged in the vicinity of an electrical conductor (8) such that when there is a significant current flow through the electrical conductor (8), the magnetic field produced triggers the switch and initiates an evaluation electronics in communication with the switch, wherein
> for a detection of surge current magnitudes and a differentiation between long-term pulsed currents, on the one hand, and short-term pulsed currents, on the other hand, a multitude of reed contacts (4; 5; 6) are arranged at prespecified, different, increasing distances from the electrical conductor (8),
> wherein the evaluation electronics determines the response and the switching times of the respective reed contacts (4; 5; 6), the surge current magnitude being determined from the association of the ascertained values with the respective reed contact (4; 5; 6) and the pulse shape being determined from the switching time.

2. The use according to claim 1, **characterized in that** the electrical conductor (8) is an integral part of a lightning current arrester line or an arrester rod.

3. The use according to claim 1, **characterized in that** the electrical conductor (8) is an integral part of a surge current-carrying overvoltage arrester.

4. The use according to any of the preceding claims, **characterized in that** the evaluation electronics includes a microcontroller (10) and a data storage.

5. The use according to claim 4, **characterized in that** the stored data is transferred in a wireless or wired manner to a superordinate unit for long-term analysis of pulse-shaped surge currents.

6. The use according to claim 4 or 5, **characterized in that** a radio module (2) is provided for data transmission, wherein the data transmission is not initiated until after expiry of a predetermined time span after decay of the last surge current pulse.

7. The use according to any of the preceding claims, **characterized in that** the device includes a self-contained long-term power supply (3).

8. The use according to any of the preceding claims, **characterized in that** at least the reed contacts (4; 5; 6) are fixed on a planar wiring carrier (1), wherein a first group of reed contacts (4; 5; 6) is arranged on one of the sides of the wiring carrier (1), and a second group of reed contacts (4; 5; 6) is arranged on the side of the wiring carrier (1) opposite the first side.

9. The use according to claim 8, **characterized in that** the angular position of the groups of reed contacts (4; 5; 6) with respect to the electrical conductor (8) is fixedly specified.

10. The use according to any of the preceding claims, **characterized in that** a housing receiving the components of the device is formed, which has a front or side surface provided with means for marking the position of and/or for attaching the electrical conductor (8).

11. The use according to any of the preceding claims, **characterized in that** the device is in each case arranged on or in the vicinity of lightning arrester cables of rotor blades in wind turbines.

12. The use according to any of the preceding claims, **characterized in that** a time stamp can be generated after expiry of a predetermined or settable time span between a pulse event and data transfer.

13. The use according to any of the preceding claims, **characterized in that** the electrical conductor (8) is an integral part of components or installations not carrying lightning current, in particular of hoisting cables or carrier cables of cableways or cranes.

## Revendications

1. Utilisation d'un dispositif de détection et de classification d'événements de courant de foudre et de courant de surcharge présentant un caractère de courant de choc dans la plage de > 50 A à 200 kA et des formes d'impulsion en tant qu'impulsion de longue durée avec T ≥ 10 ms et des formes d'impulsion de 10/350 μs et 8/20 μs,

> le dispositif comprenant au moins un contact Reed (4 ; 5 ; 6) en tant qu'interrupteur à réponse magnétique, lequel est agencé à proximité d'un conducteur électrique (8) de sorte que dans le cas d'un flux de courant significatif à travers le conducteur électrique (8), le champ magnétique produit déclenche l'interrupteur et démarre une électronique d'évaluation en communication avec l'interrupteur,
> une pluralité de contacts Reed (4 ; 5 ; 6) étant agencée à différentes distances prédéterminées et croissantes du conducteur électrique (8) pour une détection de grandeurs de courant de choc et une différenciation entre, d'une part, des courants pulsés de longue durée et, d'autre part, des courants pulsés de courte durée, l'électronique d'évaluation déterminant la réponse et les temps de commutation des contacts Reed respectifs (4 ; 5 ; 6), la grandeur du courant de choc étant déterminée à partir de l'association des valeurs déterminées au contact Reed respectif (4 ; 5 ; 6), et la forme de l'impulsion étant déterminée à partir du temps de commutation.

2. Utilisation selon la revendication 1, **caractérisée en ce que** le conducteur électrique (8) fait partie d'une dérivation de courant de foudre ou d'une tige de parafoudre.

3. Utilisation selon la revendication 1, **caractérisée en ce que** le conducteur électrique (8) fait partie d'un parasurtenseur transportant un courant de choc.

4. Utilisation selon l'une des revendications précédentes, **caractérisée en ce que** l'électronique d'évaluation comprend un microcontrôleur (10) et une mémoire de données.

5. Utilisation selon la revendication 4, **caractérisée en ce que** les données stockées sont transférées sans fil ou par câble à une unité supérieure pour une analyse à long terme de courants de choc en forme d'impulsion.

6. Utilisation selon la revendication 4 ou 5, **caractérisée en ce qu'**il est prévu un module radio (2) pour la transmission des données, la transmission des données n'étant initiée qu'après l'expiration d'une période de temps prédéterminée après l'affaiblissement de la dernière impulsion de courant de choc.

7. Utilisation selon l'une des revendications précédentes, **caractérisée en ce que** le dispositif présente une alimentation électrique autonome à long terme (3).

8. Utilisation selon l'une des revendications précédentes, **caractérisée en ce qu'**au moins les contacts Reed (4 ; 5 ; 6) sont fixés sur un support de câblage plan (1), un premier groupe de contacts Reed (4 ; 5 ; 6) étant agencé d'un des côtés du support de câblage (1), et un deuxième groupe de contacts Reed (4 ; 5 ; 6) étant agencé du côté du support de câblage (1) qui est opposé au premier côté.

9. Utilisation selon la revendication 8, **caractérisée en ce que** la position angulaire des groupes de contacts Reed (4 ; 5 ; 6) par rapport au conducteur électrique (8) est spécifiée de manière fixe.

10. Utilisation selon l'une des revendications précédentes, **caractérisée en ce qu'**un boîtier est réalisé, lequel reçoit les composants du dispositif et présente une face frontale ou latérale pourvue de moyens de marquage de la position et/ou de fixation du conducteur électrique (8).

11. Utilisation selon l'une des revendications précédentes, **caractérisée en ce que** le dispositif est respectivement agencé sur ou à proximité de câbles parafoudres des pales de rotor dans des centrales éoliennes.

12. Utilisation selon l'une des revendications précédentes, **caractérisée en ce qu'**un horodatage peut être généré après l'expiration d'une période de temps prédéterminée ou réglable entre un événement d'impulsion et le transfert de données.

13. Utilisation selon l'une des revendications précédentes, **caractérisée en ce que** le conducteur électrique (8) fait partie de composants ou d'installations ne transportant pas de courant de foudre, notamment de câbles de levage ou de câbles porteurs de téléphériques ou de grues.

Fig. 1

**4, 5, 6**    **9**    **10**    **11**

| Reed-Sensor | Tiefpassfilter | Mikrocontroller | Funkanbindung |

_Fig. 2_

Spannungsversorgung über Batterie · 5

Zeitbaustein · 13

4,5,6

9

12

10

11

Reed-Sensor

R-C - Tiefpassfilter

Komparator

Signalverarbeitung und Speicher

Low Power- Funkanbindung

Fig.3

Sensoren mit Impulserkennung

Anbindung GSM zur Cloud · 16

14

15

17

Low Power- Funkanbindung

Datenverarbeitung

Anbindung Ethernet zur Cloud

Gateway

EP 3 452 839 B1

12

**IN DER BESCHREIBUNG AUFGEFÜHRTE DOKUMENTE**

**In der Beschreibung aufgeführte Patentdokumente**

- DE 2826247 C2
- DE 10329223 B9
- DE 2700995 A1
- DE 19930089 A1
- RU 2554282 C1
- DE 19733268 A1
- WO 2017036793 A1